(19) Europäisches Patentamt

European Patent Office

Office européen des brevets

(11) **EP 1 683 896 A2**

(12) **EUROPÄISCHE PATENTANMELDUNG**

(43) Veröffentlichungstag:
**26.07.2006 Patentblatt 2006/30**

(51) Int Cl.:
***C30B 11/00*** (2006.01)   ***C30B 29/12*** (2006.01)
***G02B 1/02*** (2006.01)

(21) Anmeldenummer: **05001576.7**

(22) Anmeldetag: **26.01.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **26.01.2004   DE 102004003829**

(71) Anmelder: **Schott AG**
**55122 Mainz (DE)**

(72) Erfinder:
• **Kandler, Jörg, Dr.**
**07751 Cospeda (DE)**

• **Parthier, Lutz, Dr.**
**14532 Kleinmachnow (DE)**
• **Kaufhold, Thomas**
**07616 Bürgel (DE)**
• **Wehrhan, Gunther, Dr.**
**07749 Jena (DE)**
• **Kunisch, Clemens**
**55288 Armsheim (DE)**

(74) Vertreter: **Fuchs Mehler Weiss & Fritzsche**
**Naupliastrasse 110**
**81545 München (DE)**

(54) **Verfahren zum Reinigen von Kristallmaterial und zum Herstellen von Kristallen, eine Vorrichtung hierzu sowie die Verwendung der so erhaltenen Kristalle**

(57)   Es wird ein Verfahren zur Herstellung von Kristallen mit geringem Absorptionsverhalten, geringer diffuser Streuung und Strahlenschaden durch Aufreinigen von Kristallrohmaterial in einer Vorrichtung (100) beschrieben, die einen verschließbaren Schmelztiegel (122) zum Aufschmelzen des Kristallrohmaterials umfasst, wobei der verschließbare Schmelztiegel (122) mindestens eine Öffnung (142) aufweist. Das Verfahren umfasst ein Trocknen des Rohmaterials durch Entfernen von absorptiv, adsorptiv und/oder chemisch gebundenen Wassers, ein Umsetzen von im Rohmaterial erhaltenen Verunreinigungen mit mindestens einem Scavenger, sowie ein Homogenisieren des aufgeschmolzenen Kristallmaterials, und zeichnet sich dadurch aus, dass die Öffnung (142) definierte geometrische Leitwerte aufweist, wobei das Trocknen bei einer Temperatur von 100°C bis 600°C über einen Zeitraum von mindestens 20 Stunden bei einem geometrischen Leitwert der Öffnung von 2,00 bis 30,00 mm$^2$, das Umsetzen von Verunreinigungen mit dem Scavenger bei Temperaturen von 600°C bis 1200°C für einen Zeitraum von mindestens 9 Stunden bei einem geometrischen Leitwert der Öffnung von 0,0020 bis 0,300 mm$^2$ und die Homogenisierung bei einer Temperatur der Schmelze oberhalb 1400°C für eine Zeit von mindestens 6 Stunden und bei einem geometrischen Leitwert der Tiegelöffnung von 0,25 mm$^2$ bis 1,1 mm$^2$ durchgeführt wird, oder dass Trocknen, Umsetzen von Verunreinigungen mit dem Scavenger, Homogenisieren mit einer gleichen Öffnung erfolgt, die einen geometrischen Leitwert von 0,25 bis 1 mm$^2$ aufweist.

Fig. 2c

EP 1 683 896 A2

**Beschreibung**

Die Erfindung betrifft ein Verfahren zur Aufreinigung von insbesonders bereits hochreinem Kristallrohmaterial, zur Herstellung von Kristallen mit geringer optischer extrinsischer Absorption durch ein insbesonders mehrstufiges, das Rohmaterial weiter aufreinigendes Behandlungsverfahren, eine Vorrichtung zur Durchführung des Verfahrens, die einen verschließbaren Schmelztiegel mit mindestens einer verschließbaren Öffnung aufweist, sowie die Verwendung der hiermit erhaltenen Kristalle.

Kristalle, im besonderen Einkristalle, finden immer häufiger Verwendung zur Herstellung von optischen Elementen wie Linsen etc. Eine Vielzahl solcher Kristalle sind für hochenergetische, insbesondere auch kurzwellige Strahlung durchlässig und eignen sich daher zur Herstellung beispielsweise von optischen Systemen wie z.B. für Laser bzw. wie sie in der Mikrolithographie zur Herstellung von Schaltungen in kleinen elektrischen Bauteilen wie Computerchips notwendig sind. Durch die verstärkte Miniaturisierung derartiger Schaltungen werden nicht nur Linsen bzw. Einkristalle mit immer größeren Geometrien gefordert, sondern es werden auch die Anforderungen an Reinheit, insbesonders an die optische Reinheit von Kristallen laufend erhöht. So erzeugen beispielsweise Versetzungen und insbesonders Schlierenbildungen oder andere Eintrübungen Unschärfen in photolithographisch abgebildeten Schaltmustern, die bei der zunehmenden Miniaturisierung zu Kurzschlüssen und damit zum Versagen des ganzen Computerchips führen kann, was den Ausschuss bei deren Produktion enorm erhöht. Auch führt der durch Absorption an solchen Verunreinigungen und Störstellen verursachte Wärmeeintrag zu einer Wärmeausdehnung des optischen Elements und so zu einer Brennpunktveränderung, was ebenfalls zu einer verschlechterten Abbildung führt.

Es sind daher bereits Verfahren zur großtechnischen Herstellung orientierter Einkristalle beschrieben. Alle Verfahren haben gemeinsam, dass ein Kristallkeim mit einer Schmelze aus Kristallrohmaterial in Kontakt gebracht wird und unter Abkühlung ausgehend von einem Kristallkeim, der die Orientierung vorgibt durch Abkühlung ein Kristall erzeugt wird. So wird beispielsweise in der US-A 2,149,076 ein sog. vertikales Bridgeman-Verfahren beschrieben, bei dem ein Schmelztiegel ringförmig von übereinander angeordneten Heizmänteln umschlossen wird. Der Schmelztiegel ist entlang einer zentralen Achse innerhalb dieser Heizmäntel verschiebbar bzw. absenkbar. Werden nun an den übereinander angeordneten Heizmänteln Temperaturen angelegt, die für den oberen Mantel oberhalb der Schmelztemperatur und für den unten liegenden Mantel unterhalb der Schmelztemperatur liegen und der Tiegel langsam aus dem oberen Heizmantel in den unteren abgesenkt wird, so kühlt sich die Schmelze im Tiegel allmählich ab und ausgehend vom Kristallkeim wächst erstarrt die Schmelze unter Ausbildung eines Einkristalls.

In einer anderen Methode mit einem ebenfalls vertikalen Kristallwachstum sind mehrere relativ zum Schmelztiegel feststehende Heizelemente vorgesehen, deren Temperatur individuell steuerbar ist. Hierzu zählt auch das sog. vertical gradient freeze (VGF)-Verfahren. Dabei werden die Heizelemente individuell angesteuert, so dass ein vertikaler Temperaturgradient in der Schmelze erzeugt wird. Im Gegensatz zum zuvor genannten Bridgeman-Verfahren wird dabei jedoch das Kristallwachstum nicht durch ein Absenken des Tiegels erreicht, sondern durch eine Verringerung der Leistung der Heizelemente, so dass die Schmelze ausgehend vom Tiegelboden bzw. der Keimtasche allmählich nach oben hin abkühlt und die Phasengrenzfläche fest-flüssig unter Wachsen des Kristalles nach oben steigt. Ein derartiges Verfahren ist beispielsweise in der WO-A 01/649 75 unter anderem für Magnesiumfluorid, Bariumfluorid, Strontiumfluorid und Calciumfluorid beschrieben.

Um die notwendige Reinheit der Kristalle zu erreichen, werden diese vorzugsweise aus einem synthetisch hergestellten Pulver aus dem Kristallmaterial hergestellt. Üblicherweise beträgt dabei die Schüttdichte lediglich ca. nur ein Drittel derjenigen des fertig gezüchteten Kristalles, was bedeutet, dass eine ausreichende Menge Pulver in einen Schmelz- oder Zuchttiegel eingebracht werden muss, der mindestens die dreifache Höhe des fertigen Kristalles aufweist. Da das Aufschmelzen, Reinigen und Züchten des Kristalls speziell bei der Herstellung von großvolumigen Einkristallen einen Zeitraum von üblicherweise mehreren Monaten benötigt, ist versucht worden, das Trocknen, Reinigen und Aufschmelzen des Kristallrohpulvers, in einer separaten baulich einfachen Schmelzvorrichtung durchzuführen. Auf diese Weise werden die aufwändigen und teuren, hochsensiblen Kristallzuchtanlagen nicht durch vorbereitende Verfahrensschritte belegt und können ausschließlich für die eigentliche Kristallzucht ausgenutzt werden, was deren Rentabilität erhöht.

Die Herstellung von einzelnen Kristallrohlingen in einem Vorprozess kann daher separat in einer einfachen und kostengünstig herzustellenden Schmelzvorrichtung erfolgen, in der kein gerichtetes Kristallwachstum erfolgt, sondern ein polykristalliner Körper, ein sog. Ingot entsteht. In diesem Vorprozess wird der üblicherweise pulverförmige Rohstoff aufgeschmolzen und die damit verbundene Verdichtung des Materials zu einem kompakten Körper und die gleichzeitig mögliche Aufreinigung des Materials in einem Tiegel durchgeführt, der vorzugsweise vergleichbare Dimensionen, wie der spätere Zuchttiegel aufweist. Am Ende dieses Aufschmelzprozesses kann im Gegensatz zur reinen Kristallzucht das Material rasch auf Raumtemperatur abgekühlt werden, da keine gerichtete kristalline Erstarrung notwendig ist und ein polykristalliner Körper erhalten wird. Ein derartiger polykristalliner Körper wird üblicherweise als Ingot bezeichnet. Dieser polykristalline Ingot wird dann als Rohling für die eigentliche Kristallzucht verwendet. Die separate Ausbildung eines Ingots und spätere Kristallzucht wird als zweistufiger Prozess bezeichnet. Das Durchführen des gesamten Herstellungsverfahrens bestehend aus Aufschmelzen des Pulvers, Aufreinigung, Homogenisierung, Kristallzucht, Tempern und Abkühlen wird als einstufiger Herstellungsprozess bezeichnet.

Es hat sich gezeigt, dass die Qualität des späteren Kristalles sehr stark von den Prozessparametern der Trocknungs-, Scavenger- und Homogenisierungsphase abhängen und zwar unabhängig davon ob diese in einem einstufigen Verfahren oder in einem zweistufigen Ingotverfahren erfolgt. So beschreibt beispielsweise die DE-A 102 08 157 ein Verfahren zur Herstellung eines Fluoridkristalles, bei dem ein Fluoridrohmaterial in einem offenen Tiegel unter Vakuum getrocknet wird. Nach Verschließen des Tiegels wird das getrocknete Rohmaterial mit einem als Desoxidationsmittel bezeichneten Scavenger umgesetzt und dann nach Beendigung der Desoxireaktion wird der Tiegeldeckel wieder geöffnet, um die Scavenger-Reaktionsprodukte zu entfernen und ggf. noch nicht vollständig geschmolzenes Kristallrohmaterial fertig aufzuschmelzen.

Die Erfindung hat zum Ziel, Einkristalle, insbesondere großvolumige Einkristalle bereitzustellen, die für die Verwendung als optisches Material mit geringem extrinsischen Absorptionsverhalten geeignet sind. Dabei soll der Kristall einen möglichst geringen Anteil an Sauerstoff und geringen Anteil an diffuser Streuung aufweisen. Eine diffuse Streuung entsteht beispielsweise an Kristallanomalien, die an Kristallstörstellen auftreten.

Dieses Ziel wird nun erfindungsgemäß mit den in den Ansprüchen definierten Merkmalen erreicht. Es hat sich gezeigt, dass bei Einhaltung spezieller Prozessparameter während der Trocknung, Scavengerreaktion und vor allem auch während der Homogenisierung besonders störstellenarme bzw. störstellenfreie Einkristalle erhalten werden. Überraschenderweise wurde nämlich gefunden, dass durch eine Kombination von optimierter Temperatur, Dauer der einzelnen Verfahrensschritte und geeigneter Auswahl der Tiegelöffnung der Fremdstoffgehalt, insbesondere der Sauerstoffgehalt im Ingot bzw. im fertigen Kristall und damit auch die Streuung und Absorption im Kristall wesentlich gesenkt werden kann. Darüber hinaus kann die Strahlenbeständigkeit und der Laserschaden im Kristall ebenfalls weiter verbessert werden und so großvolumige Kristalle mit neuer verbesserter Qualität in bis dahin nicht bekannter Qualität reproduzierbar hergestellt werden.

Es hat sich erfindungsgemäß auch gezeigt, dass sich Verunreinigungen, wie Sauerstoff, dann besonders gut entfernen lassen, wenn die Geometrie der Tiegelöffnungen für die einzelnen Verfahrensschritte jeweils innerhalb eines bestimmten Bereiches liegt. Dieser Effekt lässt sich durch ein optimiertes Temperatur- und Zeitprofil weiter verbessern.

Die Erfindung betrifft daher ein Verfahren zur Aufreinigung von Kristallen sowie zur Herstellung von Einkristallen, insbesondere in einer Vorrichtung, die einen verschließbaren Tiegel zum Aufschmelzen von Kristallrohmaterial umfasst, wobei der Schmelztiegel mindestens eine verschließbare Öffnung aufweist.

Das Verfahren selbst umfasst die Trocknung des Kristallrohmaterials. Dabei wird sowohl adsorbiertes als auch absorbiertes, sowie ggf. noch vorliegendes Kristallwasser entfernt. Übliche Temperaturen zum Trocknen des Rohmaterials betragen 100°C-600°C, wobei 200°C-550°C und insbesondere 300°C-500°C bevorzugt sind. Die Dauer der Trocknung beträgt üblicherweise mindestens 20 Stunden, vorzugsweise mindestens 60 Stunden, wobei eine Trocknungsdauer von mindestens 150 Stunden ganz besonders bevorzugt ist. Für besonders große Mengen an Kristallrohmaterial, insbesondere bei einer großen Schütthöhe, können ohne weiteres auch längere Trocknungszeiten zweckmäßig sein.

In einem weiteren Reinigungsschritt werden Verunreinigungen wie beispielsweise Oxidsauerstoff mit sog. Scavengern umgesetzt, wobei störende Reaktionsprodukte, die einen niedrigeren Dampf- bzw. Sublimationspunkt aufweisen als das Kristallrohmaterial, entfernt werden. Bei Alkali- und Erdalkalihalogeniden, wie beispielsweise Kalziumfluorid, Bariumfluorid, Magnesiumfluorid, Strontiumfluorid und deren Mischungen sind übliche Scavenger $PbF_2$, $ZnF_2$ und/oder $SnF_2$. Die Temperatur zur Durchführung der Scavengerreaktion beträgt beim $PbF_2$ vorzugsweise 600°C-1200°C, wobei 700°C-1000°C, bzw. 750°C-900°C besonders bevorzugt ist. Für $ZnF_2$ betragen diese Temperaturen vorzugsweise 800 - 1400°C, wobei 900 - 1300°C und insbesondere 1000 - 1300°C besonders bevorzugt sind. Die verwendeten Mengen sind von der Qualität des Kristallrohmaterials abhängig und betragen vorzugsweise 0,5 - 3 Gew.-%. In einer besonders bevorzugten Ausführungsform wird erfindungsgemäß die Scavengerreaktion bei langsam und üblicherweise kontinuierlich steigender Temperatur durchgeführt. Dabei betragen bevorzugte Temperatursteigerungen 1°C/h bis 35°C/h, wobei 5°C/h bis 20°C/h besonders bevorzugt sind. Je nach Scavenger und nach dem Sauerstoffgehalt des Rohmaterials hat es sich als zweckmäßig erwiesen, die Erhöhung der Temperatur bei 600 - 1000°C, vorzugsweise 650 - 800°C vorzugsweise für einen Zeitraum von mindestens 100, üblicherweise 200 Stunden bis 500 Stunden anzuhalten, wobei bei niedrigeren Temperaturen eine längere Haltezeit zu wählen ist und umgekehrt.

Nach der Durchführung der Scavengerreaktion erfolgt eine Homogenisierung der Schmelze durch Erhitzen in einem Gradienten. Dies wird beispielsweise dadurch erreicht, dass der Schmelztiegel mit einem Deckel- und Bodenheizer von unterschiedlicher Temperatur erhitzt wird. Dabei haben sich Temperaturen für den oberhalb des Tiegels angeordneten Heizer von 1410°C bzw. 1450°C bis 1800°C, vorzugsweise zwischen 1500°C bis 1750°C als zweckmäßig erwiesen. Zweckmäßige Temperaturen für den unterhalb des Tiegels angeordneten Heizer betragen üblicherweise 1410°C bis 1850°C und vorzugsweise 1460°C bzw. 1500°C bis 1750°C. Obwohl auch für $BaF_2$ in den einzelnen Verfahrensstufen die erfindungsgemäßen Leitwerte sowie die obigen Temperaturen gelten, ist es auf Grund des niedrigeren Schmelzpunktes von $BaF_2$ gegebenenfalls bevorzugt, bei gleichen Homogenisierungszeiten das Verfahren bei etwas niedrigeren Temperaturen durchzuführen, z. B. beim Aufschmelzen im Gradienten mit Temperaturen des oberen Heizers von 1350-1700°C, vorzugsweise 1360-1600°C und für den unteren Heizer bei Temperaturen von 1360-1750°C, vorzugsweise 1400-1650°C. Bevorzugt werden dabei für die Homogenisierung Leitwerte von 0,10-0,50 mm². Dabei wird der Temperaturgradient vorzugsweise so eingestellt, dass die Schmelze am Boden des Tiegels heißer ist als am oberen Ende des Tiegels. Vorzugsweise herrscht dabei ein axialer Temperaturgradient von mindestens 0,25°C/cm, insbesonders mindestens 1°C. Die Homogenisierung ist ggf. auch durch mechanisches Rühren erreichbar. Dies kann sowohl mittels einem in die Schmelze eintauchenden klassischen Rührelement erfolgen, als auch durch eine Rotation des Schmelztiegels. Besonders zweckmäßig sind Tiegelrotationen mit wechselnder, gegenläufiger Drehrichtung. Eine Vorrichtung zur Durchführung einer solchen Rotationshomogenisierung ist beispielsweise in der parallelen DE-A 103 47 430 der gleichen Anmelderin beschrieben. Die Dauer der Homogenisierung beträgt zweckmäßigerweise mindestens 6 Stunden, wobei mindestens 24 Stunden und insbesonders mindestens 100 Stunden besonders bevorzugt sind.

Erfindungsgemäß hat sich nun gezeigt, dass das Entfernen von Feuchtigkeit, Produkten der Scavengerreaktion, sowie sonstigen Verunreinigungen besonders erfolgreich ist, wenn für die einzelnen Schritte, Trocknung, Scavengerreaktion und Homogenisierung jeweils besonders dimensionierte Tiegelöffnungen vorliegen. Erfindungsgemäß soll für die Trocknung ein geometrischer Leitwert der Öffnung von 2 bis 30 mm², vorzugsweise von 2,25 bis 24,75 mm² verwendet werden. Für die Phase der Scavengerreaktion werden erfindungsgemäß geometrische Leitwerte der Öffnungen von 0,0020 bis 0,30 mm², vorzugsweise 0,0025 bis 0,27 mm² Die Homogenisierung wird erfindungsgemäß bei geometrischen Leitwerten der Öffnung von 0,25 bis 2,30 mm², vorzugsweise 0,80 bis 1,20 mm² durchgeführt. Es wurde gefunden, dass mit diesen Leitwerten ein besonders reiner, insbesondere sauerstofffreier Kristall erhalten werden kann, der ein geringes Absorptionsverhalten und eine geringe Streuung zeigt.

In einer erfindungsgemäßen alternativen Ausführungsform können alle drei Verfahrensschritte, d.h. Trocknung, Scavengerreaktion sowie Homogenisierung mit nur einer Lochgröße durchgeführt werden, wenn deren geometrischer Leitwert Lg 0,20 - 1,5 mm², vorzugsweise 0,25 bis 1 mm² aufweist.

Der geometrische Leitwert $L_g$ einer Öffnung ist das Produkt aus der Durchtrittswahrscheinlichkeit eines Teilchens $\Omega$ und der Fläche der Öffnung A und ist somit ein Maß für den Teilchenstrom. Lg hat die Einheit einer Fläche, da die Durchtrittswahrscheinlichkeit eine dimensionslose Größe angibt. Der geometrische Leitwert wird deshalb definitionsgemäß auch als ein Wirkungsquerschnitt bezeichnet gemäß folgender Formel:

$$L_g \; = \; A \; * \; \Omega$$

wobei für eine runde Öffnung, d. h. eine runde Bohrung mit einem Bohrlochradius r und einer Bohrlochlänge 1 sich die Durchtrittswahrscheinlichkeit $\Omega$ nach der folgenden Formel berechnet:

$$\Omega = \; 1/\left\{1+(^3/_8 * 1 * \Phi/r)\right\}$$

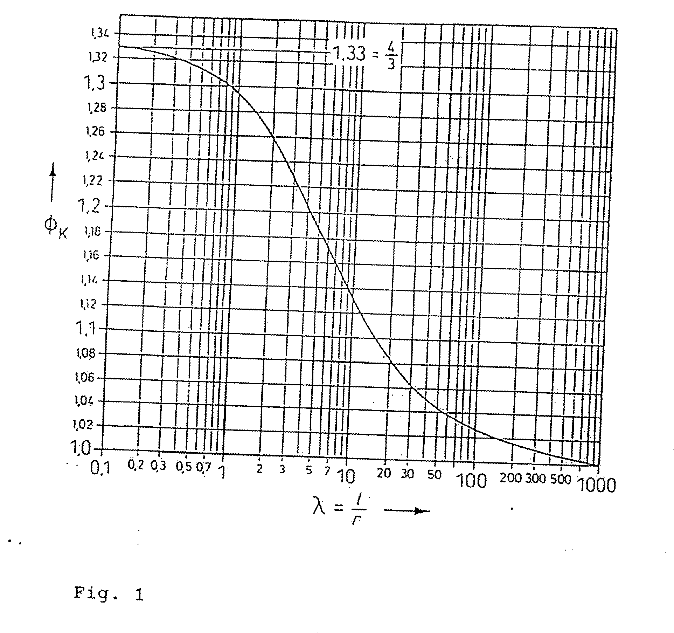

wobei $\Phi$ einen Korrekturfaktor darstellt und einen Wert zwischen 1,0 und 1,33 bedeutet. Die Bestimmung des Korrekturfaktors ist beispielsweise mittels der beiliegenden Fig.1a entnehmbar. Die Bestimmung von Leitwerten ist dem Fachmann an sich bekannt und beispielsweise im Handbuch "Vakuumtechnik, Theorie und Praxis" von Wutz, Adam und Walcher, 6. Auflage, 1997, Vieweger Verlag, Seite 102 ff. beschrieben. Darin sind auch Korrekturkurven für Öffnungen mit rechteckigen und elliptischen Querschnitten angegeben.

Das erfindungsgemäße Verfahren ist für Alkali- und Erdalkalifluoride, insbesonders für Kalziumfluorid, Bariumfluorid, Magnesiumfluorid, Strontiumfluorid und deren Mischungen geeignet, wobei unter den Mischkristallen solche aus Kalzium- und Strontiumfluorid ganz besonders bevorzugt sind.

Die Erfindung betrifft auch eine Vorrichtung zur Durchführung des Verfahrens. Die Vorrichtung umfasst einen verschließbaren Tiegel zum Aufschmelzen des Kristallrohmaterials. Der Tiegel selbst enthält einen Innenraum zur Aufnahme des Rohmaterials, sowie einen Deckel mit einer Öffnung, die ggf. auch verschließbar ausgestaltet sein kann. Darüber hinaus umfasst die erfindungsgemäße Vorrichtung eine Vakuumvorratskammer, die über die Tiegel- bzw. Dekkelöffnung mit dem Innenraum des Tiegels in Verbindung steht bzw. mit diesem kommuniziert. Außerdem umfasst die erfindungsgemäße Vorrichtung noch Heizelemente zum Aufheizen des Tiegelinnenraumes, sowie ggf. thermische Isolatoren und Elemente zur gleichmäßigeren Verteilung der von den Heizelementen abgegebenen Wärme. In der erfindungsgemäßen Vorrichtung weist der Tiegeldeckel eine Tiegelöffnung mit einem Verschluss auf, mit dem diese Tiegelöffnung, insbesonders die geometrischen Leitwerte der Tiegelöffnung verändert werden können. Dies ist beispielsweise mittels eines Schiebemechanismus durchführbar, der unterschiedlich große Bohrungen mit erfindungsgemäßen Leitwerten aufweist. In einer weiteren alternativen erfindungsgemäßen Ausführungsform kann die variierbare Tiegelöffnung auch durch mechanisch oder magnetisch ansteuerbare Ventile ausgebildet sein. Dabei ist es möglich, die jeweiligen gewünschten geometrischen Leitwerte durch eine unterschiedliche Stellung der Ventile, d. h. entsprechenden Öffnungsgrad oder -winkel als auch durch völliges Öffnen und Schließen von Ventilen unterschiedlicher Gestaltung zu erreichen. Mechanische Ventile können beispielsweise durch einen mechanisch von außen bewegbaren Mechanismus geöffnet oder geschlossen werden. Bei der mechanischen Ansteuerung werden beispielsweise mechanische Elemente, die ggf. in eine Graphitbeschichtung eingebettet sind bzw. komplett aus Graphit bestehen, auf dem Fachmann bekannte Weise bewegt. Die erfindungsgemäße Vorrichtung zeichnet sich nun dadurch aus, dass die Tiegel- bzw. Dekkelöffnung bzw. -öffnungen mittels den zuvor genannten Steuermechanismen zumindest auf die Leitwerte von 2 bis 30 mm$^2$, insbesondere 2,2 bis 25 mm$^2$, vorzugsweise von 2,25 bis 24,75 mm$^2$, sowie von 0,0020 bis 0,30 mm$^2$, insbesondere 0,0025 bis 0,27 mm$^2$, und von 0,25 bis 2,30 mm$^2$, insbesondere 0,30 bis 1,0 mm$^2$ geregelt werden kann.

Die Erfindung soll an den folgenden Beispielen näher erläutert werden. Es zeigen

Fig.l eine Kurve zur Bestimmung des Korrekturfaktors Φ für eine runde Deckelöffnung bzw. Bohrung.

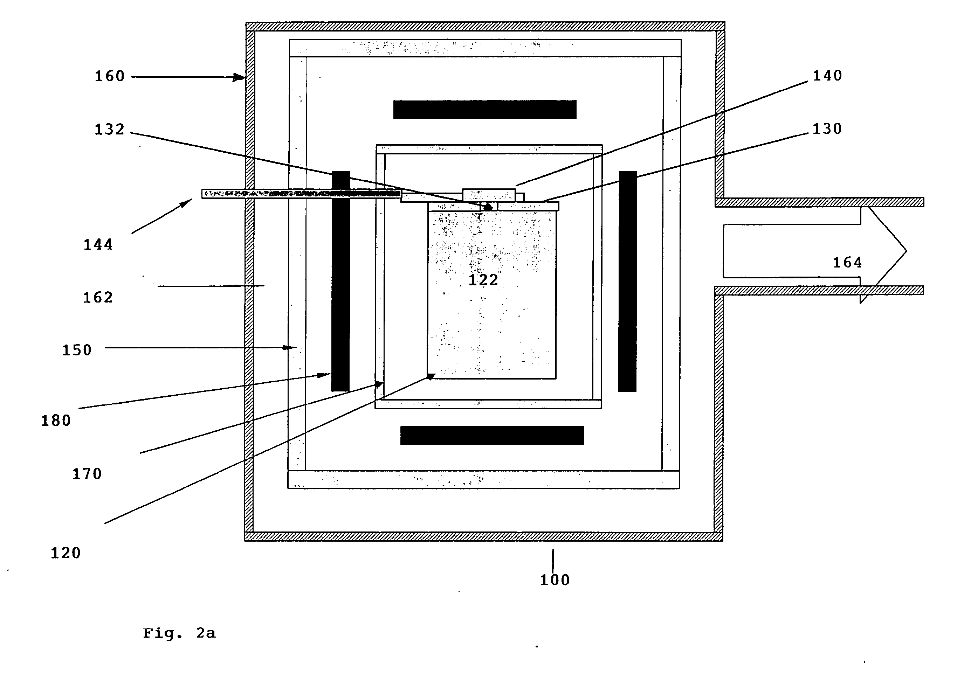

Fig.2a zeigt eine erfindungsgemäße Vorrichtung der Schmelzanlage und

Fig.2b einen Querschnitt durch einen isolierten, mit einem mit Deckel versehenen Schmelztiegel und

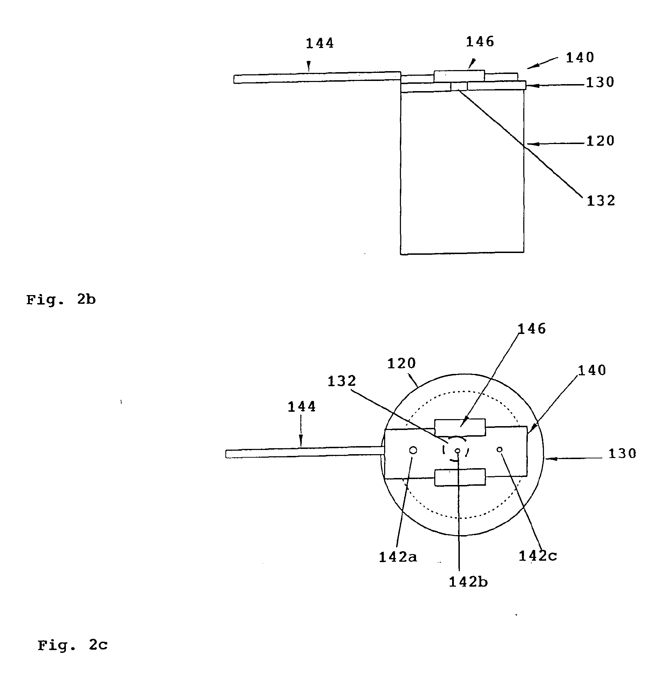

Fig.2c die Draufsicht über einen Deckel mit variierbarer Deckelöffnung.

Die erfindungsgemäße Vorrichtung 100 umfasst einen Schmelztiegel 120, der einen Deckel 130 aufweist. Der Dekkel 130 selbst weist eine verschließbare Öffnung 132 auf, die mit einer verschiebbaren Platte 140 abgedeckt ist. Die Platte 140 wird mittels einer Seitenführung 146 bzw. einem Niederhalter 146 auf der Deckelöffnung 132 verschiebbar gehalten. Die verschiebbare Platte 140 weist drei Bohrungen 142 a b c mit unterschiedlichen Bohrdurchmessern auf. Die jeweiligen Bohrungen 142 entsprechen den in den Ansprüchen angegebenen geometrischen Leitwerten. Die verschiebbare Platte 140 ist mittels einer Schubstange 144, die durch das äußere Gehäuse 160 der Vorrichtung reicht, verschiebbar. Auf diese Weise ist es möglich, je nach Verfahrensstufe den hierfür benötigten geometrischen Leitwert der Tiegelöffnung 132 einzustellen. Der Tiegel 120 selbst ist von Platten 170 umgeben, welche die Wärme der oberhalb, unterhalb und seitlich angeordneten Heizelemente 180 verteilen. Nach außen ist die Anlage gegen Wärmeverlust durch eine Isolation 150 gedämmt. Das Innere des Gehäuses 160 dient als Vakuumvorratsraum 162, welcher über die Öffnung 132 im Tiegeldeckel 130 mit dem Tiegelinneren 122 kommuniziert, so dass abgedampfte Teilchen aus dem Tiegelinneren 122 in den Vakuumvorratsraum 162 gelangen können und sich dort ggf. in Kühlfallen (nicht dargestellt) ansammeln können. Das äußere Gehäuse 160 weist eine Öffnung 164 auf, die mit einer Vakuumquelle verbunden ist.

Die mit dem erfindungsgemäßen Verfahren erhaltenen großvolumigen Kristalle, insbesondere solche aus Kalziumfluorid, Bariumfluorid, Magnesiumfluorid, Strontiumfluorid und aus deren Mischungen, eignen sich besonders zur Herstellung von optischen Komponenten für die DUV-Lithographie sowie zur Herstellung von mit Photolack beschichteten Wafern und somit zur Herstellung von elektronischen Geräten. Die Erfindung betrifft daher auch die Verwendung der mittels dem erfindungsgemäßen Verfahren und/oder in der erfindungsgemäßen Vorrichtung hergestellten Einkristalle zur Herstellung von Linsen, Prismen, Lichtleitstäben, optischen Fenstern sowie optischen Geräten für die DUV-Lithographie insbesondere zur Herstellung von Steppern und Excimerlasern und somit auch zur Herstellung von integrierten Schaltungen sowie elektronischer Geräte wie Computerchips enthaltenden Computern sowie andere elektronische Geräte, welche chipartige integrierte Schaltungen enthalten.

Beispiel 1:

In einen Schmelztiegel wurden 60 kg hochreinen synthetischen Kalziumfluoridpulvers, bei dem die kationischen Verunreinigungen typischerweise < 1ppm liegen, zugegeben, dem 1 Gew.-% eines PbF$_2$, (übliche Mengen betragen 0,5 - 3 Gew.-%) homogen untergemischt war. Der Tiegel wurde nun mittels einem eine Öffnung aufweisenden Deckel verschlossen. Auf dem Deckel wurde ein plattenförmiger Schiebemechanismus zum Verschließen der Öffnung angeordnet, wobei der Mechanismus Löcher mit jeweils einer Lochbohrung von 4 mm, 0,15 mm und 1,2 mm Radius bei einer Bohrlochlänge von 10 mm enthielt, was einem geometrischen Leitwert von 24,7461 mm$^2$, 0,0025 mm$^2$ und 1,0195 mm$^2$ entspricht. Nach dem Einfüllen und Verschließen wurde an das Tiegeläußere ein Vakuum von 0,9 *10$^{-3}$ Pa (0,9*10$^{-5}$ mbar) und eine der Bohrungen als Tiegelöffnung eingestellt. Dann wurde 100 bzw. 150 Stunden lang bei 450°C getrocknet. Anschließend wurde die Temperatur auf 700°C erhöht und von dort mit einer Aufheizrate von 12°C pro Stunde auf 1000°C erhöht. Anschließend wurde 80 bzw. 120 Stunden lang homogenisiert, wobei an das obere Heizelement 1500°C und das untere Heizelement 1600°C angelegt wurde, was einem axialen Temperaturgradienten von etwa 1°C/cm im Tiegel entspricht. Nach der Beendigung ließ man die Schmelze mit einer Geschwindigkeit von 5°C pro Stunde abkühlen und nach dem Erstarren wurde mit 15°C pro Stunde bis auf 200°C weiter abgekühlt. Aus diesen Rohlingen wurden wie in der WO-A-01/649 75 beschrieben orientierte großvolumige Einkristalle mit einem Durchmesser von 385 mm und einer Höhe von 161 mm hergestellt.

Dieses Verfahren wurde nun mit unterschiedlichen Tiegelöffnungen durchgeführt. Dabei wurde sowohl der Verlust an Material im Tiegel, als auch der Sauerstoffgehalt am Rohling sowie am fertigen Kristall bestimmt. Der Sauerstoffgehalt wurde mittels SIMS (Sekundäre Ionenmassenspektroskopie) ermittelt. Dabei wird während der Messung die Oberfläche einer zu untersuchenden Probe mit ionisierendem Edelgas beschossen, wodurch bei längerem Beschuss (Sputtern) ein Abtrag der Oberfläche bis zu einigen $\mu$m erfolgt. Mit fortschreitendem Abtrag stabilisiert sich die Konzentration an Sauerstoff. Ein stabiles Signal entspricht dann der in einem Volumen vorliegenden Sauerstoffmenge.

Ebenfalls bestimmt wurde die diffuse Streuung im fertigen Kristall. Dabei wird die Streuung derart ermittelt, dass ein Betrachter die Streuung in vier Stufen klassifiziert, wobei ein Wert von 0 keine visuell wahrnehmbare Streuung bedeutet, 1 eine schwache Streuung, 2 eine mittlere Streuung und 3 eine starke Streuung anzeigt.

Die Bestimmung der Streuung erfolgt optisch mit dem Auge. Dabei wird in einem abgedunkelten Raum die Probe mit einer Stechlampe untersucht und mit Standardproben verglichen.

Die Absorption wird durch Bestimmung des $k_0$-Wertes ermittelt. Dabei ist der $k_0$-Wert ein berechneter Absorptionskoeffizient für eine Strahlung mit der Energiedichte 0. Zu dessen Bestimmung wird eine 10 cm lange Kristallprobe an ihren Stirnflächen poliert, um die Oberflächenverluste in der Nähe des aus den fresnellschen Formeln berechneten Reflektionsverlustes zu halten. Zur Messung selbst wird ein Laserstrahl mittels eines Strahlteilers geteilt wobei ein Strahl durch die Probe auf einen ersten Detektor und der andere Strahl als Referenzstrahl direkt auf einen zweiten Detektor geleitet wird. Auf diese Weise ist es möglich, durch Schwankungen oder Driften der Laserintensität auftretende Messfehler zu vermeiden. Mit dieser Vorrichtung wird die Transmission für verschiedene, üblicherweise drei verschiedene Energiedichten $\varepsilon_1$ bis $\varepsilon_3$ ermittelt. Typische Energiedichten liegen im Bereich von 1 mJ/cm$^2$ und 100 mJ/cm$^2$. Zur Bestimmung des gesuchten Absorptionskoeffizienten $k_0$, d. h. des Absorptionskoeffizienten für die Energiedichte $\varepsilon_0=0$ werden die jeweils erhaltenen K-Werte über die $\varepsilon$-Werte aufgetragen und $K_0$ durch Extrapolation und einem linearen Fit der experimentell erhaltenen Datenpunkte $\varepsilon_1$ $k_1$, $\varepsilon_2$ $k_2$ und $\varepsilon_3$ $k_3$ ermittelt. Auf diese Weise wurden die in der folgenden Tabelle angegebenen Werte erhalten. Wie sich dieser Tabelle entnehmen lässt, zeigen die mittels dem erfindungsgemäßen Verfahren erhaltenen Kristalle nicht nur eine äußerst verbesserte geringe Absorption sondern sie zeigen auch keine erkennbare diffuse Streuung. Darüber hinaus zeigen sämtliche Kristalle bzw. Kristallrohlinge einen deutlich verringerten Sauerstoffgehalt.

Tabelle 1 experimentelle Befunde mit nur einer Lochbohrung

| Lg *1) | Verlust an CaF2 pro Tiegel [g] | O-Gehalt im Ingot [ppm]*2) | O-Gehalt im Kri-stall*3 ) [ppm] | diffus Streuung im Kri-stall beobachtet | Absorptions-koeffizient k0 157 nm 157 (Kristall) [1/cm] Anfang | Absorptions-koeffizient k0 nm (Kristall) [1/cm] Ende |
|---|---|---|---|---|---|---|
| Ohne Lochbohrung | 20 | 22 | 12 | Stark | 1,5E-03 | 2,1E-03 |
| 0,0025 | 32 | 12 | 10 | Gering | 1,1E-03 | 1,5E-03 |
| 0,0301 | 81 | 8 | 7 | Nein | 3,0E-04 | 6,8E-04 |
| 0,2719 | 152 | 10 | 8 | Nein bis gering | 4,4E-04 | 4,7E-04 |
| 1,0195 | 256 | 5 | 6 | Nein | 2,1E-04 | 3,6E-04 |
| 2,2477 | 360 | 9 | 6 | Nein bis gering | 5,4E-04 | 6,6E-04 |
| 24,7461 | 1280 | 20 | 11 | Mittel | 1,3E-03 | 2,5E-03 |

Trocknen, Scavengerreaktion sowie Homogenisieren wurden hier mit jeweils nur einer Lochgröße durchgeführt.

Tabelle 2 experimentelle Befunde Schieberanlage

| Exp | Lg in PP Trckn. *3) | Lg in PP Scav. *4) | Lg in PP Hmg. *5) | Verlust an $CaF_2$ pro Tiegel [g] | O-Gehalt im Ingot [ppm] *1) | O-Gehalt im Kristall *2) [ppm] | diffus Streuung im Kristall beobachtet | Absorptions-koeffizient $k_0$ 157 nm (Kristall) [1/cm] Anfang | Absorptions-koeffizient $k_0$ 157 nm (Kristall) [1/cm] Ende |
|---|---|---|---|---|---|---|---|---|---|
| 1 Vergleich | 0,03 01 | 0,00 25 | 1,0195 | 265 | 13 | 10 | Gering | 5,9E-04 | 8,1E-04 |
| 2 vergleich | 0,03 01 | 0,27 19 | 1,0195 | 240 | 8 | 5 | Nein | 4,5E-04 | 5,5E-04 |
| 3 Vergleich | 0,03 01 | 2,24 77 | 1,0195 | 250 | 12 | 11 | Nein bis gering | 4,0E-04 | 8,6E-04 |
| 4 vergleich | 0,27 19 | 0,27 19 | 0,2719 | 152 | 10 | 8 | Nein bis gering | 4,4E-04 | 4,7E-04 |
| 5 | 1,01 95 | 1,01 95 | 1,0195 | 256 | | 6 | Nein | 2,1E-04 | 3,6E-04 |
| 6 Vergleich | 2,24 77 | Tiegel zu | 1,0195 | 268 | 15 | 13 | Mittel | 5,8E-04 | 7,2E-04 |
| 7 | 2,24 77 | 0,00 25 | 1,0195 | 271 | 3 | 2 | Nein | 7,2E-05 | 8,4E-05 |
| 8 | 2,24 77 | 0,27 19 | 1,0195 | 242 | 4 | 3 | Nein | 8,3E-05 | 8,3E-05 |
| 9 vergleich | 2,24 77 | 2,24 77 | 2,2477 | 360 | 9 | 6 | Nein bis gering | 5,4E-04 | 6,6E-04 |
| 10 | 24,7 461 | 0,00 25 | 1,0195 | 254 | 5 | 2 | Nein | 5,5E-05 | 7,7E-05 |
| 11 | 24,7 461 | 0,27 19 | 1,0195 | 259 | 3 | 3 | Nein | 8,5E-05 | 9,5E-05 |
| 12 | 24,7 461 | 2,24 77 | 1,0195 | 248 | 10 | 8 | Gering | 4, 4E-04 | 7, 5E-04 |

*1) 1 ppm = 1 mg pro 1 kg

*2) Mittelwert einer Messprobe jeweils aus Ende und Anfang des Kristalls

*3) Lg in Prozessphase Trocknen

*4) Lg in Prozessphase Scavenger

*5) Lg in Prozessphase Homogenisierung

EP 1 683 896 A2

Bezugszeichenliste:

| | |
|---|---|
| 100 | Vorrichtung |
| 120 | Schmelztiegel |
| 122 | Tiegelinnenraum |
| 130 | Deckel |
| 132 | Deckelöffnung |
| 140 | verschiebbare Platte |
| 142 | Bohrung |
| 144 | Schubstange |
| 146 | Seitenführung und Plattenniederhalter |
| 150 | Isolator |
| 160 | äußeres Gehäuse |
| 162 | Gehäuseinneres, Vakuumvorrat |
| 164 | Vakuumleitung |
| 170 | Platte |
| 180 | Heizer |

**Patentansprüche**

**1.** Verfahren zur Herstellung von Kristallen mit geringem Absorptionsverhalten, geringer diffuser Streuung und Strahlenschaden durch Aufreinigen von Kristallrohmaterial in einer Vorrichtung, die einen verschließbaren Schmelztiegel zum Aufschmelzen des Kristallrohmaterials umfasst, wobei der verschließbare Schmelztiegel mindestens eine Öffnung aufweist, umfassend

- Trocknen des Rohmaterials durch Entfernen von absorptiv, adsorptiv und/oder chemisch gebundenen Wassers,
- Umsetzen von im Rohmaterial erhaltenen Verunreinigungen mit mindestens einem Scavenger,
- Homogenisieren des aufgeschmolzenen Kristallmaterials,

**dadurch gekennzeichnet, dass**
die Öffnung definierte geometrische Leitwerte aufweist und
das Trocknen bei einer Temperatur von 100°C bis 600°C über einen Zeitraum von mindestens 20 Stunden bei einem geometrischen Leitwert der Öffnung von 2,00 bis 30,00 mm$^2$, vorzugsweise von 2,25 bis 24,75 mm$^2$,
das Umsetzen von Verunreinigungen mit dem Scavenger bei Temperaturen von 600°C bis 1200°C für einen Zeitraum von mindestens 9 Stunden bei einem geometrischen Leitwert der Öffnung von 0,0020 bis 0,300 mm$^2$ durchgeführt wird, und
die Homogenisierung bei einer Temperatur der Schmelze oberhalb 1400°C für eine Zeit von mindestens 6 Stunden und bei einem geometrischen Leitwert der Tiegelöffnung von 0,25 mm$^2$ bis 1,1 mm$^2$ durchgeführt wird,
 oder dass Trocknen, Umsetzen von Verunreinigungen mit dem Scavenger, Homogenisieren mit einer gleichen Öffnung erfolgt, die einen geometrischen Leitwert von 0,25 bis 1 mm$^2$ aufweist.

**2.** Verfahren nach Anspruch 1, **dadurch gekennzeichnet, dass** das Verfahren bei einem Vakuum von mindestens 10 Millibar durchgeführt wird.

**3.** Verfahren nach einem der vorhergehenden Ansprüche, **dadurch gekennzeichnet, dass** das Homogenisieren durch Anlegen eines axialen Temperaturgradienten in der Schmelze von mindestens 0,25°C/cm erfolgt.

**4.** Verfahren nach einem der vorhergehenden Ansprüche, **dadurch gekennzeichnet, dass** als Scavenger ein Halogenid von Pb, Zn, und/oder Sn verwendet wird.

**5.** Vorrichtung zur Herstellung von insbesondere großvolumigen Kristallen mit geringer Absorption, geringer diffuser Streuung und geringem Strahlenschaden umfassend einen verschließbaren Tiegel (120) zum Schmelzen von Kristallrohmaterial, der einen mit einer verschließbaren Öffnung (132) aufweisenden Innenraum (122) zur Aufnahme des Kristallrohmaterials enthält, eine Vakuumvorratskammer (162), die über die Öffnung (132) mit dem Innenraum (122) des Tiegels (120) kommuniziert, sowie mindestens ein Heizelement (180) zum Aufheizen des Tiegelinnenraumes (122), sowie ggf. Wärmeisolatoren (150) und Wärmeverteilelemente (170), **dadurch gekennzeichnet, dass** die Tiegelöffnung (132) variierbar ist und mindestens drei verschiedene Öffnungsgrößen (142) aufweist, die einen geometrischen Leitwert von 2,2 bis 25,00 mm$^2$, 0,002 bis 0,30 mm$^2$ und von 0,25 bis 1,1 mm$^2$ aufweist.

6. Vorrichtung nach Anspruch 5, **gekennzeichnet durch** einen mit einem die geometrischen Leitwerte aufweisenden Löchern versehenen Schieber (140).

7. Vorrichtung nach Anspruch 5, **dadurch gekennzeichnet, dass** die Öffnungen (132) durch ein Ventil mit einem steuerbaren variablen geometrischen Leitwert aufweist.

8. Verwendung von mit dem Verfahren und/oder der Vorrichtung enthaltenen Kristallen zur Herstellung von optischen und elektronischen Bauteilen.

9. Großvolumiger Einkristall mit einem Durchmesser von mindestens 20 cm, und einer Höhe von mindestens 20cm der keine optisch wahrnehmbare Streuung, einen $k_0$-Wert von $10^{-5}$, sowie einen Sauerstoffgehalt von maximal 4 ppm aufweist.

Fig. 1

Fig. 2a

Fig. 2b

Fig. 2c